# EUROPÄISCHE PATENTSCHRIFT

(11) **EP 0 881 665 B1**
(45) Veröffentlichungstag und Bekanntmachung des Hinweises auf die Patenterteilung: **01.02.2006**
(21) Anmeldenummer: 98890156.7
(22) Anmeldetag: 22.05.1998
(51) Int. Cl.: H01L 21/00

(54) **Anordnung zum Behandeln scheibenförmiger Gegenstände**
Treatment device for disk-like substrates
Dispositif de traitement de substrats en forme de disque

(30) Priorität: 23.05.1997 AT 88797
(43) Veröffentlichungstag der Anmeldung: 02.12.1998
(73) Patentinhaber: SEZ AG, 9500 Villach (AT)
(72) Erfinder: Sumnitsch, Franz, 9020 Klagenfurt (AT)
(74) Vertreter: Beer, Manfred

(56) Entgegenhaltungen:
- US-A- 5 472 502
- US-A- 5 487 398
- PATENT ABSTRACTS OF JAPAN vol. 013, no. 379 (C-628), 22. August 1989 (1989-08-22) & JP 01 129973 A (HITACHI LTD;OTHERS: 01), 23. Mai 1989 (1989-05-23)
- PATENT ABSTRACTS OF JAPAN vol. 1995, no. 01, 28. Februar 1995 (1995-02-28) & JP 06 302553 A (HITACHI LTD), 28. Oktober 1994 (1994-10-28)

## Beschreibung

Die Erfindung betrifft Anordnungen mit den Merkmalen der einleitenden Teile von Anspruch 1 und von Anspruch 6.

Aus der US-5,472,502 A ist eine Anordnung zum Behandeln scheibenförmiger Gegenstände mit einem Träger für den scheibenförmigen Gegenstand, welchem Träger ein Antrieb zum Drehen des Trägers um seine Achse zugeordnet ist, sowie mit einer Einrichtung zum Zuführen eines Behandlungsfluids. Über dem Träger ist eine Haube angeordnet. Der Haube ist eine Leitung zum Zuführen von Lösungsmitteldampf , in den Innenraum der Haube zugeordnet. Die Haube ist über dem Träger, den an ihm gehaltenen Gegenstand zur Gänze überdeckend angeordnet, wobei zwischen dem Träger bzw. dem an ihm gehaltenen Gegenstand und dem unteren Ende der Haube ein Ringspalt vorliegt.

Die bekannte Anordnung soll das Abdampfen von Lösungsmittel aus dem Behandlungsfluid verzögern durch Bilden einer mit LösungsmittelDampf angereicherten Umgebung im Bereich des scheibenförmigen Gegenstandes.

Bei bestimmten Verfahren zum Behandeln von scheibenförmigen Gegenstände, insbesondere von (Silizium-)Wafern, traten insbesondere beim Spülen der Wafer, nachdem sie mit dem Behandlungsmedium, z.B. mit einem Ätzfluid, behandelt worden sind, insoferne Probleme auf, als sich auf der Oberfläche des Wafer Flecken bildeten. Diese Flecken entstehen dadurch, dass die (Silizium-)Oberfläche des scheibenförmigen Gegenstandes, insbesondere des (Silizium-)Wafer, in Gegenwart von Wasser und von Sauerstoff oxidiert wird.

Der Erfindung liegt die Aufgabe zu Grunde, die Bildung solcher "Wasserflecken" zu vermeiden.

Gelöst wird diese Aufgabe mit einer Anordnung mit den Merkmalen des Anspruches 1 und mit einer Änderung mit den Merkmalen des Anspruches 6.

Bevorzugte und vorteilhafte Ausgestaltungen der erfindungsgemäßen Anordnung sind Gegenstand der Unteransprüche.

Dadurch, dass an der Oberseite des Trägers für den scheibenförmigen Gegenstand, z.B. dem (Silizium-)Wafer eine Haube angeordnet ist, die mit einem Inertgas, z.B. Stickstoff, beaufschlagt wird, wird die Luft, welche die Bildung von Wasserflecken verursacht, aus dem Prozessraum unmittelbar über dem scheibenförmigen Gegenstand verdrängt.

Dadurch, dass gemäß einem Vorschlag der Erfindung die Haube unabhängig von dem Träger für den scheibenförmigen Gegensand ausgebildet ist, also still steht, ergibt sich eine einfache Konstruktion, wobei dennoch das Zuführen der Prozessfluide und des Intergases ohne weiteres möglich ist. Das zugeführte Inertgas und zugeführte Behandlungsfluide werden in einer Ausführungsform der Erfindung durch die Haube aufgebracht, wobei das zugeführte Inertgas unerwünschte Luft aus dem Prozeßraum verdrängt.

Bei der erfindungsgemäßen Anordnung ist die Ausführung und die Konstruktion des Trägers für den scheibenförmigen Gegenstand nicht wesentlich. Es können beliebige, auch bekannte Konstruktionen solcher Träger Verwendung finden.

Ein vorteilhafter Effekt der erfindungsgemäßen Anordnung besteht darin, daß sich in der Haube unter der Wirkung des sich drehenden scheibenförmigen Gegenstandes ein Unterdruck ausbildet, der die Reinigungswirkung unterstützt, und der durch das Ausmaß des Zuführens von Inertgas, die Drehzahl des Trägers für den scheibenförmigen Gegenstand und die Breite des Spaltes zwischen dem unteren Rand der Haube und dem Träger bzw. dem scheibenförmigen Gegenstand auf den beispielsweise für das Spülen jeweils optimalen Wert eingestellt werden kann.

Weitere Einzelheiten, Merkmale und Vorteile der Erfindung ergeben sich aus der nachstehenden Beschreibung zweier Ausführungsbeispiele der Anordnung gemäß der Erfindung.

Es zeigt:
Fig. 1 eine erste Ausführungsform schematisiert in Seitenansicht, teilweise geschnitten, und
Fig. 2 eine andere Ausführungsform, teilweise geschnitten.

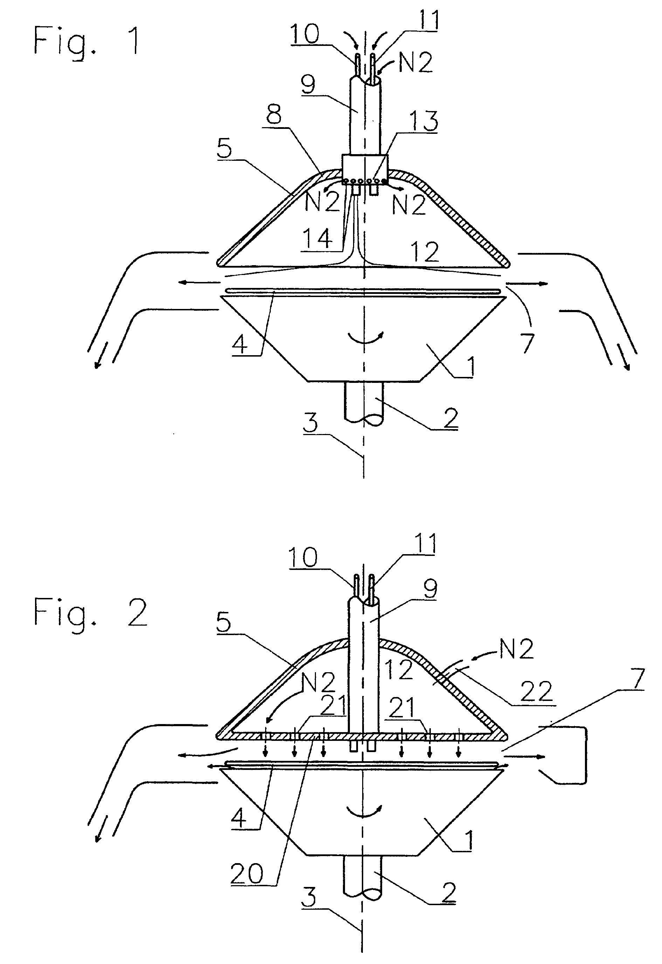

Bei der in Fig. 1 gezeigten Ausführungsform ist über einem Träger 1, der von einer Welle 2 getragen und durch einen der Welle 2 zugeordneten Antrieb um seine Achse 3 drehbar ist, eine im Ausführungsbeispiel etwa glockenförmige Haube 5 angeordnet. Die glockenförmige Haube 5 wird so über dem Träger 1 angeordnet, daß ein auf ihm festgehaltener, scheibenförmiger Gegenstand 4, z.B. ein (Silizium-)Wafer, vom unteren, offenen Ende 6 der Haube 5 zur Gänze abgedeckt wird. Zwischen der Anordnung aus Träger 1 und Wafer 4 (der Wafer 4 kann auch einen Durchmesser besitzen, der größer ist als jener des Trägers 1) einerseits und der glockenförmigen Haube 5 anderseits befindet sich ein Ringspalt 7.

Im Bereich des oberen, mittleren Endes 8 der Haube 5 ist diese mit einem hohlen Tragerohr 9 verbunden, durch das Leitungen 10 und 11 zum Zuführen von Medien führen. Im einzelnen sind in dem in Fig. 1 gezeigten Ausführungsbeispiel (wenigstens) eine Leitung 10 für das Zuführen eines Behandlungsfluids und eine Leitung 11 zum Zuführen eines Spülmediums, z.B. deionisiertem Wasser, vorgesehen, die beide im Bereich des oberen Endes 8 der Haube 5 in dem von der Haube 5 umschlossenen Raum 12 ausmünden.

Durch das hohle Tragerohr 9 wird weiters ein Inertgas, z.B. Stickstoff, zugeführt, das im Bereich des oberen Endes 8 der Haube 5 durch eine Düsenanordnung 13 in den Raum 12 in der Haube 5 austritt. Die Düsen 14 der Düsenanordnung 13 sind so ausgerichtet, daß Inertgas aus der Düsenanordnung 13 annähernd radial austritt und den gesamten Raum 12 gleichmäßig mit Inertgas füllt, um Luft aus dem Raum 12 zu verdrängen.

Die in Fig. 2 gezeigte Ausführungsform der erfindungsgemäßen Anordnung unterscheidet sich von der in Fig. 1 gezeigten vornehmlich dadurch, daß das untere Ende 6 der Haube 5 durch eine Wand 20 verschlossen ist. In der Wand 20 sind mehrere, zur Achse 3, beispielsweise im wesentlichen parallel ausgerichtete, Bohrungen 21, die über die Fläche der Wand 20 verteilt angeordnet sind, vorgesehen. Weiters ist bei der in Fig. 2 gezeigten Ausführungsform das Tragerohr 9 für die Haube 5 bis zur Wand 20 verlängert. Die Leitungen 10 und 11 münden auf der dem Gegenstand 4 bzw. dem Träger 1 zugekehrten Seite der Wand 20 aus. So werden Behandlungsfluide in Nähe des scheibenförmigen Gegenstandes 4 austreten und auf diesen zentral aufgebracht. An der Seitenwand der Haube 5 ist eine Leitung 22 angeschlossen, durch die ein Inertgas (z.B. Stickstoff) in den Raum 12 innerhalb der Haube 5 eingeleitet werden kann. Das in den Raum 12 eingeleitete Inertgas tritt gleichmäßig über die gesamte Fläche des Gegenstandes 4 verteilt durch die Öffnungen 21 aus und bewirkt, daß Luft aus dem Raum zwischen der Wand 20 und dem Gegenstand 4 verdrängt wird, so daß dort eine Inertgasatmosphäre vorliegt.

Bei beiden Ausführungsformen der erfindungsgemäßen Anordnung steht die Haube 5 still und es dreht sich nur der Träger 1 mit dem an ihm gehaltenen Gegenstand 4.

Um das Auflegen von scheibenförmigen Gegenständen 4 auf den Träger 1 und das Abnehmen der Wafer 4 vom Träger 1 zu erleichtern, kann die Haube 5 aus ihrer dem Träger 1 angenäherten Wirklage (Fig. 1 und 2) wegbewegt werden.

Zusammenfassend kann ein bevorzugtes Ausführungsbeispiel der erfindungsgemäßen Anordnung zum Behandeln scheibenförmiger Gegenstände, insbesondere von Siliziumwafer , wie folgt beschrieben werden:

Bei einer Anordnung zum Behandeln von Siliziumwafern 4 ist ein Träger 1 zum Behandeln der Siliziumwafer 4 vorgesehen, der über eine Welle 2 um seine Achse 3 in Drehung versetzbar ist. Über der den Siliziumwafer 4 tragenden Fläche des Trägers 1 ist eine Haube 5 angeordnet, die sich nicht dreht, wenn ein scheibenförmiger Wafer 4 behandelt wird. In den Innenraum der Haube 12 wird Inertgas, vornehmlich Stickstoff, eingeleitet, so daß Luft aus dem von der Haube 5 umschlossenen Raum 12 verdrängt wird. Dadurch wird die Bildung von Flecken durch Oxidation des Silizium, aus dem der Wafer besteht, in Gegenwart von Wasser und Sauerstoff verhindert.

## Patentansprüche

1. Anordnung zum Behandeln scheibenförmiger Gegenstände (4) mit einem Träger (1) für den scheibenförmigen Gegenstand (4), welchem Träger (1) ein Antrieb zum Drehen des Trägers (1) um seine Achse (3) zugeordnet ist, sowie mit Leitungen (10, 11) zum Zuführen wenigstens eines Behandlungsfluids und eines Spülfluids, wobei, über dem Träger (1) eine Haube (5) angeordnet ist, die Haube (5) von einem Rohr (9) gehalten ist, durch das die Leitungen (10, 11) zum Zuführen des Behandlungsfluids bis in den oberen Teil (8) der Haube (5) geführt sind, das mit der Haube (5) verbundene Rohr (9) eine Leitung (9) zum Zuführen von Inertgas in den Innenraum (12) der Haube (5) ist, im oberen Teil (8) der Haube (5) eine Düsenanordnung (13) mit mehreren Düsen (14) für den Austritt von über das Rohr (9) zugeführtem Inertgas vorgesehen ist, die Haube (5) über dem Träger (1), den an ihm gehaltenen Gegenstand (4) zur Gänze überdekkend angeordnet ist, und zwischen dem Träger (1) bzw. dem an ihm gehaltenen Gegenstand (4) und dem unteren Ende (6) der Haube (5) ein Ringspalt (7) für den Austritt von Behandlungsfluid und Inertgas vorliegt.

2. Anordnung nach Anspruch 1 zum Behandeln von Siliziumwafern.

3. Anordnung nach Anspruch 1 oder 2, **gekennzeichnet durch** eine Leitung (9) zum Zuführen von Stickstoff als Inertgas.

4. Anordnung nach einem der Ansprüche 1 bis 3, **dadurch gekennzeichnet, daß** die Haube (5) koaxial zum Träger (1) angeordnet ist.

5. Anordnung nach einem der Ansprüche 1 bis 4, **dadurch gekennzeichnet, daß** die Haube (5) an ihrem dem Träger (1) zugekehrten Ende (6) offen ist.

6. Anordnung zum Behandeln scheibenförmiger Gegenstände (4) mit einem Träger (1) für den scheibenförmigen Gegenstand (4), welchem Träger (1) ein Antrieb zum Drehen des Trägers (1) um seine Achse (3) zugeordnet ist, sowie mit Leitungen (10, 11) zum Zuführen wenigstens eines Behandlungsfluids und eines Spülfluids, wobei, über dem Träger (1) eine Haube (5) angeordnet ist, mit der Haube (5) eine Leitung (22) zum Zuführen von Inertgas in den Innenraum (12) der Haube (5) verbunden ist, die Haube (5) an ihrem dem Träger (1) bzw. dem Gegenstand (4) zugekehrten Ende durch eine Wand (20) verschlossen ist, in der Wand (20) Bohrungen (21) vorgesehen sind, durch die Inertgas aus der Haube (5) in den Raum zwischen der Wand (20) und dem scheibenförmigen Gegenstand (4) austreten kann, die Leitungen (10, 11) auf der dem Träger (1) zugekehrten Seite der Wand (20) münden, die Haube (5) über dem Träger (1), den an ihm gehaltenen Gegenstand (4) zur Gänze überdeckend angeordnet ist, und zwischen dem Träger (1) bzw. dem an ihm gehaltenen Gegenstand (4) und dem unteren Ende (6) der Haube (5) ein Ringspalt (7) für den Austritt von Behandlungsfluid und Inertgas vorliegt.

7. Anordnung nach Anspruch 6 zum Behandeln von Siliziumwafern.

8. Anordnung nach Anspruch 6 oder 7, **gekennzeichnet durch** eine Leitung (9, 22) zum Zuführen von Stickstoff als Inertgas.

9. Anordnung nach einem der Ansprüche 6 bis 8, **dadurch gekennzeichnet, daß** die Haube (5) koaxial zum Träger (1) angeordnet ist.

10. Anordnung nach einem der Ansprüche 5 bis 9, **dadurch gekennzeichnet, daß** die Haube (5) von einem hohlen Rohr (9) gehalten ist, durch das die Leitungen (10, 11) zum Zuführen von Behandlungsfluid geführt sind und daß das Rohr (9) bis zur Wand (20) reicht.

11. Anordnung nach einem der Ansprüche 1 bis 10, **dadurch gekennzeichnet, daß** die Haube (5) beim Behandeln eines scheibenförmigen Gegenstandes (4) still steht.

## Claims

1. Device for treating disk-like substrates (4), having a carrier (1) for the disk-like substrate (4), to which carrier (1) a drive for rotating the carrier (1) about its axis (3) is assigned, and also having pipes (10, 11) for supplying at least one treatment fluid and one rinsing fluid, wherein a hood (5) is disposed above the carrier (1), the hood (5) is retained by a pipe (9) through which the pipes (10, 11) for supplying treatment fluid into the upper part (8) of the hood (5) are led, the pipe (9) connected to the hood (5) is a pipe (9) for supplying inert gas into the interior (12) of the hood (5), a nozzle arrangement (13) with a plurality of nozzles (14) for the discharge of inert gas supplied via the pipe (9) is provided in the upper part (8) of the hood (5), the hood (5) is disposed above the carrier (1), covering the substrate (4) retained thereon in its entirety, and an annular gap (7) for the discharge of treatment fluid and inert gas is present between the carrier (1) or the substrate (4) retained thereon and the lower end (6) of the hood (5).

2. Device according to claim 1 for treating silicon wafers.

3. Device according to claim 1 or 2, **characterised by** a pipe (9) for supplying nitrogen as inert gas.

4. Device according to one of the claims 1 to 3, **characterised in that** the hood (5) is disposed coaxially to the carrier (1).

5. Device according to one of the claims 1 to 4, **characterised in that** the hood (5) is open at its end (6) orientated towards the carrier (1).

6. Device for treating disk-like substrates (4), having a carrier (1) for the disk-like substrate (4), to which carrier (1) a drive for rotating the carrier (1) about its axis (3) is assigned, and also having pipes (10, 11) for supplying at least one treatment fluid and one rinsing fluid, wherein a hood (5) is disposed above the carrier (1), a pipe (22) for supplying inert gas into the interior (12) of the hood (5) is connected to the hood (5), the hood (5) is closed by a wall (20) at its end orientated towards the carrier (1) or the substrate (4), borings (21) are provided in the wall (20) through which inert gas can discharge from the hood (5) into the space between the wall (20) and the disk-like substrate (4), the pipes (10, 11) discharge on the side of the wall (20) orientated towards the carrier (1), the hood (5) is disposed above the carrier (1), covering the substrate (4) retained thereon in its entirety, and an annular gap (7) for the discharge of treatment fluid and inert gas is present between the carrier (1) or the substrate (4) retained thereon and the lower end (6) of the hood (5).

7. Device according to claim 6 for treating silicon wafers.

8. Device according to claim 6 or 7, **characterised by** a pipe (9, 22) for supplying nitrogen as inert gas.

9. Device according to one of the claims 6 to 8, **characterised in that** the hood (5) is disposed coaxially to the carrier (1).

10. Device according to one of the claims 5 to 9, **characterised in that** the hood (5) is retained by a hollow pipe (9) through which the pipes (10, 11) for supplying treatment fluid are led, and **in that** the pipe (9) extends up to the wall (20)

11. Device according to one of the claims 1 to 10, **characterised in that** the hood (5) is stationary during treatment of a disk-like substrate (4).

## Revendications

1. Dispositif pour le traitement d'objets (4) en forme de disque, comportant un support (1) pour l'objet (4) en forme de disque, support (1) auquel est associé un mécanisme d'entraînement pour mettre ledit support (1) en rotation autour de son axe (3), ainsi que des conduites (10, 11) pour amener au moins un fluide de traitement et un fluide de rinçage, dans lequel un capot (5) est disposé au-dessus du support (1), le capot (5) est supporté par un tube (9) à l'intérieur duquel passent les conduites (10, 11) pour amener le fluide de traitement jusque dans la région supérieure du capot, le tube (9) lié au capot (5) est une conduite pour alimenter l'espace intérieur (12) du capot (5) en gaz inerte, il est prévu dans la partie supérieure (8) du capot (5) un agencement de buses (13) comprenant plusieurs buses (14) pour la sortie du gaz inerte amené via le tube (9), le capot (5) est disposé au-dessus du support (1) de telle sorte qu'il couvre totalement l'objet (4) fixé sur celui-ci, et un espace annulaire (7) pour la sortie du fluide de traitement et du gaz inerte est prévu entre le support (1), voire l'objet (4) fixé sur celui-ci, et l'extrémité inférieure (6) du capot (5).

2. Dispositif selon la revendication 1, pour le traitement de plaquettes de silicium.

3. Dispositif selon la revendication 1 ou 2, **caractérisé par** une conduite (9) pour l'alimentation en azote comme gaz inerte.

4. Dispositif selon une des revendications 1 à 3, **caractérisé par le fait que** le capot (5) est coaxial avec le support (1).

5. Dispositif selon une des revendications 1 à 4, **caractérisé par le fait que** le capot (5) est ouvert à son extrémité (6) tournée vers le support (1).

6. Dispositif pour le traitement d'objets (4) en forme de disque, comportant un support (1) pour l'objet (4) en forme de disque, support (1) auquel est associé un mécanisme d'entraînement pour mettre ledit support (1) en rotation autour de son axe (3), ainsi que des conduites (10, 11) pour amener au moins un fluide de traitement et un fluide de rinçage, dans lequel un capot (5) est disposé au-dessus du support (1), une conduite (22) pour amener du gaz inerte dans l'espace intérieur (12) du capot (5) est reliée audit capot (5), le capot (5) à son extrémité tournée vers le support (1) ou l'objet (4) est fermé par une paroi (20), il est prévu dans la paroi (20) des trous (21) par lesquels du gaz inerte peut sortir du capot (5), dans l'espace entre la paroi (20) et l'objet (4) en forme de disque, les conduites (10, 11) débouchent dans la face de la paroi (20) tournée vers le support (1), le capot (5) est disposé au-dessus du support (1) de telle sorte qu'il couvre totalement l'objet (4) fixé sur celui-ci, et un espace annulaire (7) pour la sortie du fluide de traitement et du gaz inerte est prévu entre le support (1), voire l'objet (4) fixé sur celui-ci, et l'extrémité inférieure (6) du capot (5).

7. Dispositif selon la revendication 6, pour le traitement de plaquettes de silicium.

8. Dispositif selon la revendication 6 ou 7, **caractérisé par** une conduite (9, 22) pour l'alimentation en azote comme gaz inerte.

9. Dispositif selon une des revendications 6 à 8, **caractérisé par le fait que** le capot (5) est coaxial avec le support (1).

10. Dispositif selon une des revendications 5 à 9, **caractérisé par le fait que** le capot (5) est supporté par un tube (9) creux, dans lequel passent les conduites (10, 11) pour l'alimentation de fluide de traitement et que le tube (9) s'étend jusqu'à la paroi (20).

11. Dispositif selon une des revendications 1 à 10, **caractérisé par le fait que** le capot (5), pendant le traitement d'un objet (4) en forme de disque, est immobile.
